Europäisches Patentamt

(19) European Patent Office

Office européen des brevets

(11) Publication number: **0 308 588 B1**

(12) **EUROPEAN PATENT SPECIFICATION**

(45) Date of publication of patent specification:
03.04.91 Bulletin 91/14

(51) Int. Cl.$^5$: **H01L 21/20, H01L 21/84**

(21) Application number: 88109806.5

(22) Date of filing: 08.07.85

(54) Semiconductor-on-insulator fabrication method.

(30) Priority: 01.08.84 US 636730

(43) Date of publication of application:
29.03.89 Bulletin 89/13

(45) Publication of the grant of the patent:
03.04.91 Bulletin 91/14

(84) Designated Contracting States:
DE FR GB IT NL

(56) References cited:
THIN SOLID FILMS, vol. 113, no. 4, March 1984,
pages 327-335, Elsevier Sequoia, Lausanne,
CH; W. SCHARFF et al.: "Growth of monocrys-
talline silicon islands on insulating sub-
strates"
JOURNAL OF APPLIED PHYSICS, vol. 54, no.
5, May 1983, pages 2847-2849, American Insti-
tute of Physics, New York, US; Y. KUNII et al.:
"Solid-phase lateral epitaxy of chemical-
vapor-deposited amorphous silicon by fur-
nace annealing"
Journal of the Electrochemical Society, vol.
128, Sep. 1981, p. 1981-1986; H.W. LAM et al.

(61) Publication number of the earlier application in
accordance with Art. 76 EPC: 0191037

(73) Proprietor: AMERICAN TELEPHONE AND
TELEGRAPH COMPANY
550 Madison Avenue
New York, NY 10022 (US)

(72) Inventor: Ng, K.K.
275 Garfield Street
Berkeley Heights New Jersey 07922 (US)
Inventor: Sze, Simon Min
132 Burlington Road
Murray Hill New Jersey 07974 (US)

(74) Representative: Watts, Christopher Malcolm
Kelway et al
AT&T (UK) LTD. AT&T Intellectual Property
Division 5 Mornington Road
Woodford Green Essex IG8 0TU (GB)

## Description

Background of the Invention

1. Field of the Invention

The invention pertains generally to fabrication of semiconductor devices and, more particularly, of semiconductor-on-insulator devices.

2. Art Background

Semiconductor-on-insulator (SOI) devices are semiconductor devices which are formed on an electrically insulating region of a substrate. Such a region includes, for example, a layer of insulating material (material having a bandgap greater than about 3 eV), e.g., a layer of $SiO_2$, overlying semiconductor material such as silicon.

SOI devices offer several advantages over conventional semiconductor devices. For example, SOI devices offer the possibility of lower parasitic capacitances, and thus faster switching times. In addition, the undesirable phenomenon of latchup (regarding latchup, see, e.g., S.M. Sze, ed., VLSI Technology, McGraw Hill, New York, 1983, page 481), often exhibited by conventional CMOS (complementary metaloxide-semiconductor) devices, is avoided by CMOS devices in an SOI configuration. SOI devices are also less susceptible to the adverse effects of ionizing radiation and thus are more reliable. Further, the possibility of achieving relatively high speed integrated circuits without using relatively small-dimension design rules, through the fabrication of multi-level integrated circuits, i.e., circuits where one layer of devices is fabricated on top of, and electrically connected to, an underlying layer of devices, is also offered by SOI technology.

SOI fabrication techniques, such as the lateral seeding process, although advantageous, present difficulties. In the lateral seeding process, as described by LAM et al, "Single Crystal Silicon-on-Oxide by a Scanning CW Laser Induced Lateral Seeding Process," Journal of the Electrochemical Society. 128, 1981 (1981), a scanning CW laser is used to propagate single crystal structure from a single crystal region through an adjacent layer of polycrystalline silicon (polysilicon) deposited onto a substrate surface which includes a region of (insulating) silicon dioxide. As noted by Lam et al, supra, at page 1983, the lateral seeding process displaces the oxide regions from their original positions. If the original positions of the oxide regions had corresponded to the positions of the components of an IC, as defined by a mask set, then, as stated by Lam et al, the displacement of the oxide regions would cause severe difficulty in placing each IC component in a silicon region overlying an oxide region. This displacement problem largely precludes the use of available circuit designs and mask sets, in conjunction with the lateral seeding process (as currently practiced), for fabricating SOI ICs.

Thus, fabrication methods which permit the use of available circuit designs and mask sets to form SOI ICs, are an elusive goal.

## Summary of the Invention

The fabrication method according to the invention is set out in the claims.

## Brief Description of the Drawings

Some embodiments of the invention will now be described by way of example with reference to the accompanying drawings, wherein :
FIGS. 1-2 and 3-5 depict, respectively, the initial steps of two alternative processes embodying the invention ;
FIG. 6 depicts the subsequent step common to both processes ; and
FIGS. 7-8 and 9-11 depict, respectively, alternative forms of steps following that of FIG. 6.

## Detailed Description

The following method for fabricating SOI ICs permits the fabrication of such ICs using available circuit designs and available apparatus for delineating (on a substrate surface) the corresponding circuit patterns, e.g., mask sets or programmed, direct write machines. This method involves the formation of a precursor substrate surface which includes islands of electrically insulating material, each of which is substantially encircled by a crystallization seeding area of substantially single crystal semiconductor material. (An island is substantially encircled by a seeding area if seeding area adjoins at least 50 percent, preferably at least 75 percent, and most preferably 100 percent, of the periphery of the island.) The boundaries of the islands are defined with a first pattern delineating device, such as a mask or a programmed, direct write machine, which is substantially identical, in terms of the pattern it yields, to a second pattern delineating device. The latter device is one component, e.g., one mask, of an apparatus for defining on a substrate the circuit patterns needed to produce an IC, such as an IC mask set, the component being used to define the boundaries of the device regions (each of which includes one or more devices), e.g., GASAD regions, of the IC. Thus, for example, a mask taken from an available IC mask set and normally used to define the boundaries of device regions, is used to define the boundaries of the islands. For purposes of the invention, the first pattern delineating device is substantially identical to the second pattern delineating device provided each island, as delineated by the first delineating device, encompasses the corresponding device region, as delineated by the second delineating device. Furthermore, the distance between each point on the boundary of an island, as delineated by the first delineating device, and the closest point on the boundary of the corresponding device region, as delineated by the second delineating device, prior to the crystallization step (described below), is less than about 2 μm.

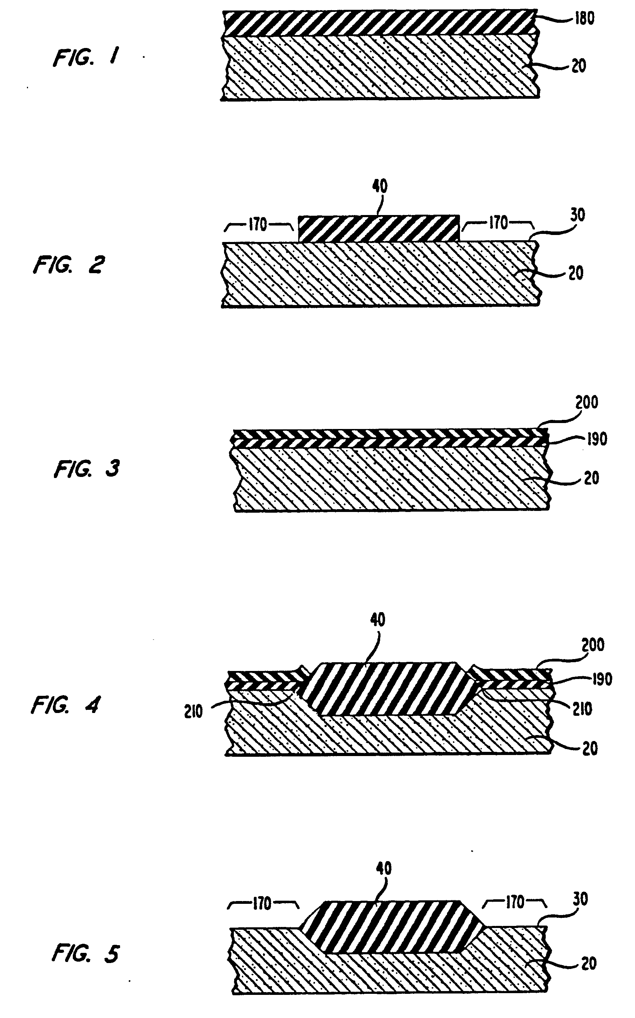

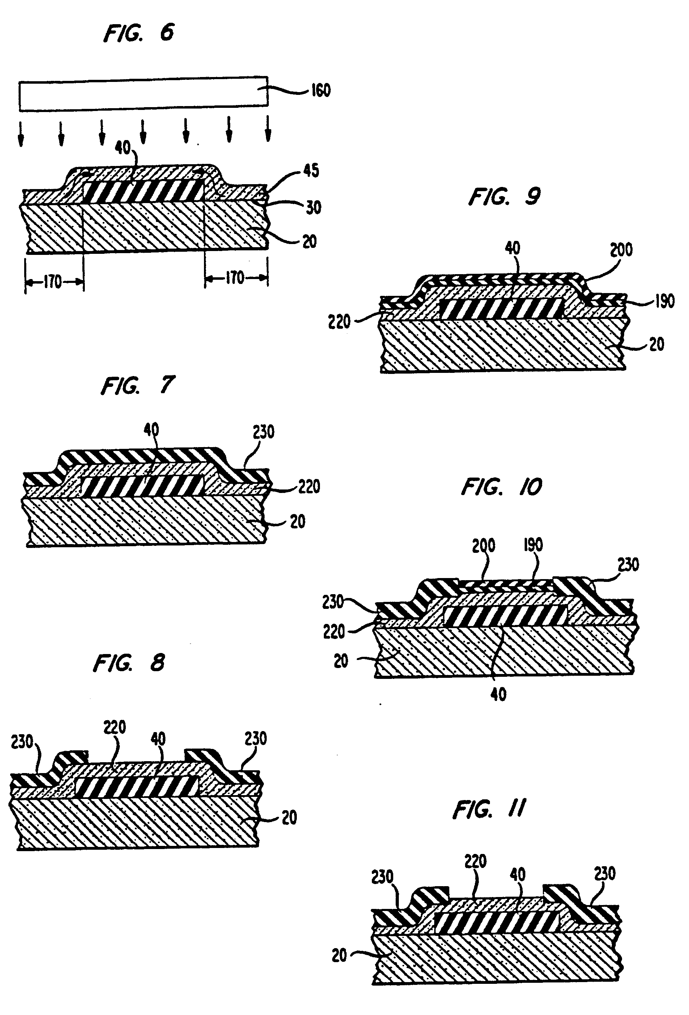

The particular lithographic technique used to form a precursor surface 30 (see FIGS. 2 and 5) which includes islands 40 of insulating material, each of which is substantially encircled by substantially single crystal semiconductor material 170, is not critical to the invention. Two convenient techniques involve the SORT (selective oxidation for reduced topology) and non-SORT processes (see, e.g., Sze, supra, at pages 462 and 464), which are normally used to form the FD between the device regions of conventional ICs. For example, if the non-SORT process is employed to form the islands of insulating material on a substrate 20, e.g., a substrate of substantially single crystal Si, then a layer 180 of insulating material, such as a layer of $SiO_2$, is initially formed on the surface of the substrate (see FIG. 1). A layer 180 of $SiO_2$ is, for example, grown on the surface of a silicon substrate using conventional thermal oxidation techniques. The thickness of the layer 180 (and thus the thickness of the subsequently formed islands) is preferably greater than about 50 nm. A thickness less than about 50 nm is undesirable because this results in devices, e.g., MOSFETs, formed on the islands which exhibit undesirably large capacitances, such as undesirably large drain-to-substrate-capacitances.

The layer 180 is selectively etched to form the desired islands 40, with each island encircled by the substantially single crystal semiconductor material 170 of the substrate 20 (as shown in FIG.2). If the layer 180 is, for example, of $SiO_2$, then the islands 40 are readily formed by selectively reactive ion etching the $SiO_2$ in an atmosphere of $CHF_3$. The selective etching is achieved by lithographically delineating the islands with, for example, a mask, referred to here as the island-forming mask, which is substantially identical (as defined above), in terms of the pattern it yields, to the mask of an IC mask set used to define the device regions of an IC, and referred to here as the device mask. (A mask is a pattern-bearing device used in patterning substrates which, when interposed between an energy-sensitive material called a resist and an appropriate source of energy, e.g., electromagnetic radiation, electrons, or ions, yields a desired pattern in the resist, i.e., selected portions of the resist undergo a change in solubility or reactivity in relation to a given developing agent or etchant. After development, the pattern defined in the resist is transferred into an underlying substrate using, for example, an etching procedure.)

Preferably, the boundary of each island extends beyond that of the device region (in all directions) by an amount (less than 2 μm) which is at least equal to the alignment error inherent in the lithographic procedures used to form the IC component (in the subsequently deposited semiconductor material) on the island. For example, the alignment error associated with present-day, commercial photolithographic techniques is about 1 μm. Consequently, the boundary of each island preferably extends about 1 μm (in all directions) beyond the boundary of its corresponding device region. However, the largest lateral extent of an island is preferably less than about 100 μm, or less than about 10 μm, depending on the technique used to crystallize the non-single crystal semiconductor material subsequently deposited onto the island (as discussed below).

A convenient non-SORT procedure for forming islands 40 which essentially coincide with the boundaries of the device regions involves the use of a resist which is of opposite tone from that normally used to define the device regions of the corresponding conventional IC. In accordance with this technique, the resist (of opposite tone) is deposited onto the layer 180 and exposed through the device mask. During development (and because of the difference in tone), only the resist external to the device regions is dissolved. Thus, when the insulating layer 180 is etched through the patterned resist, the insulating material external to the device regions is etched away, leaving islands of insulating material 40 covering the device regions.

If the SORT process is used to form islands 40 of, for example, $SiO_2$ on a substrate 20 which includes Si then, as shown in FIG. 3, successive layers 190 and 200 of $SiO_2$ and $Si_3N_4$ are initially formed on the substrate. The $SiO_2$ layer 190 is, for example, grown by oxidizing the substrate 20 using conventional thermal oxidation techniques, while the $Si_3N_4$ layer 200 is deposited by conventional chemical vapor deposition techniques. The $SiO_2$ layer 190 serves to protect the underlying Si from collisional and chemical pitting by the deposited $Si_3N_4$, while the $Si_3N_4$ layer 200 (after being patterned) serves as an oxidation mask during the oxidative growth of the $SiO_2$ islands 40 on the device regions.

The thickness of the $SiO_2$ layer 190 ranges from about 10 nm to about 1 μm. A thickness less than about 10 nm is undesirable because so small a thickness is ineffective to protect the underlying Si against damage from the $Si_3N_4$. A thickness greater than about 1 μm is undesirable because this often results in the lateral extent of the $SiO_2$ islands being undesirably large.

The thickness of the $Si_3N_4$ layer 200 ranges from about 20 nm to about 1 μm. A thickness less than about 20 nm is undesirable because so thin a layer is ineffective to act as an oxidation mask ($O_2$ penetrates

the Si₃N₄ to form $SiO_2$ in regions other than the device regions). A thickness greater than about 1 μm is undesirable because deposition and patterning times are undesirably long. Moreover, so great a thickness produces undesirably large stresses in the (subsequently formed) $SiO_2$ islands, particularly at the birds' beaks 210 of the $SiO_2$ islands (see FIG. 4).

The $SiO_2$ and $Si_3N_4$ layers are selectively (using the island-forming mask) dry (plasma assisted) etched in an atmosphere of, for example, $CHF_3$, to expose the regions where islands are to be formed. Thereafter $SiO_2$ islands 40 are grown by conventional thermal oxidation techniques on the exposed regions (see FIG.4), and the patterned $Si_3N_4$ and $SiO_2$ layers are removed with, for example, hot phosphoric acid and hydrofluoric acid, respectively (see FIG. 5). As shown in FIGS. 4 and 5, the islands 40 are generally not coplanar with the surface of the substrate. If desired, the islands 40 are made coplanar by etching back the islands with, for example, hydrofluoric acid. If the $SiO_2$ islands 40 are not etched back, then the thickness of each island ranges from about 50 nm to about 1 μm. A thickness less than about 50 nm is undesirable for the reason given above.A thickness greater than about 1 μm is undesirable because this yields a substrate surface having undesirably large deviations from planarity (a substantially planar surface is preferable during lithographic processing) and also yields undesirably large stresses at the birds' beaks 210. If the $SiO_2$ islands 40 are etched back, then the initial thickness of each $SiO_2$ island is preferably large enough so that after etching, the resulting thickness falls within the specified range.

After the formation of the islands 40, a layer 45 (see FIG. 6) of non-single crystal, i.e., amorphous or polycrystalline, semiconductor material is formed on, e.g., deposited onto, the precursor surface 30. The thickness of the layer 45 ranges from about 20 nm to about 1 μm. Layers thinner than about 20 nm are undesirable because they are often physically discontinuous. Layers thicker than about 1 μm are undesirable because it is difficult to diffuse dopants through so great a thickness of (crystallized) material to form device components, e.g., the source and drain of a MOSFET.

The non-single crystal semiconductor material overlying each island 40 is then crystallized, i.e., converted to substantially single crystal semiconductor material, using one of two techniques. In both techniques, the temperature of the non-single crystal semiconductor material on the island and on the adjacent, encircling seeding area is raised above room temperature (above about 23 degrees C). For example, in the first technique, crystallization is achieved by substantially simultaneously melting (the melting point of all useful materials is above room temperature) essentially all of the non-single crystal material both on the island and on the adjacent, encircling seeding area. (For purposes of the invention, material is substantially simultaneously melted provided melting is not initiated in any portion of the material undergoing melting after any other portion has already resolidified. Essentially all of the material is melted provided at least fifty percent of the material, both on the island and on the adjacent seeding area, undergoes melting.)

Substantially simultaneous melting is achieved, for example, by exposing the substrate to a wide area energy source 160 (depicted in FIG.6) which is essentially stationary relative to the precursor surface 30, and whose output impinges the whole precursor surface. Thus, essentially all of the non-single crystal semiconductor material covering the surface 30 is substantially simultaneously melted. Alternatively, this is achieved by successively exposing the non-single crystal material contacting each island (or two or more islands) to an energy source which is stationary (during each melting procedure) relative to the precursor surface 30, but whose output impinges just the non-single crystal material covering the island (or islands) and the adjacent seeding area (or areas). Whichever procedure is employed, sufficient energy is employed to melt both the non-single crystal semiconductor material on each island and on each crystallization seeding area 170, and at least a portion of the substantially single crystal semiconductor material in each seeding area.

During subsequent cooling and resolidification, crystallization initially occurs within the melted material on a seeding area 170, and is then radially propagated (from all directions) into the deposited material on the adjacent island 40 (as shown by the arrows in FIG. 6). It has been found that this radial propagation generally extends no more than about 50 μm, and to ensure that essentially all of the deposited material on an island 40 is crystallized, the greatest lateral extent of an island is preferably less than about 100 μm.

Despite the melting of the semiconductor material in the seeding areas 170 (as in the conventional laser processing technique), there is, unexpectedly, little or no displacement of the islands 40 from their original positions.

Among the energies which are useful for melting the layer 45 are radiant energy (electromagnetic radiation), electron beams, and ion beams. The minimum energy per unit mass, $e_m$, which must be absorbed by the semiconductor material of layer 45 to produce melting is given by

$$e_m = c(T_{mp} - T) + e_f,$$

where

  c = specific heat of the semiconductor material,
  $T_{mp}$ = melting point temperature of the semiconductor material,

$T$ = temperature of the semiconductor material prior to energy impingement, e.g., room temperature, and

$e_f$ = latent heat of fusion of the semiconductor material.

(In regard to $e_m$ see, e.g., C. E. Mortimer, Chemistry, A Conceptual Approach (Reinhold, New York, 1967, pages 6 and 168).) Thus, the minimum energy density (energy per unit volume), $e_d$, which must be absorbed by the semiconductor material of layer 45 to achieve melting is just

$$e_d = e_m \times \rho$$

where

$\rho$ = density of the semiconductor material.

All of the above parameters including $\underline{c}$, $T_{mp}$, $e_f$, and $\rho$ are readily found for a particular semiconductor material in standard references such as the Handbook of Chemistry and Physics, Robert C. Weast, ed., 63rd edition (1982-83). Therefore, $e_d$ is readily calculated. For example, in the case of polysilicon (initially at a temperature of, for example, 23 degrees C), the calculated minimum energy density is $5.6 \times 10^3$ joules/cm$^3$. Consequently, for a layer of polysilicon having a thickness of 1 µm, the minimum energy intensity (energy per unit area) required to produce melting is 0.56 joules/cm$^2$ ($= 5.6 \times 10^3$ joules-cm$^{-3}$ $\times 1$ µm), from which the power intensity (power per unit area emitted by the energy source) and exposure time are readily determined (power intensity × exposure time = energy intensity).

An energy source which provides just the minimum energy density will not, in general, produce melting because at least a portion of the incident energy will be dissipated through, for example, heat conduction, rather than absorbed. Thus, the energy density required to produce melting must generally be determined empirically by exposing control samples to increasing energy densities. However, the calculated energy density provides a useful starting point in the empirical procedure.

In the case of, for example, polysilicon, it has been found that the minimum energy density required to actually produce melting is about 10$^5$ joules/cm$^3$. Thus, for a 1 µm-thick layer of polysilicon, the minimum required energy intensity is about 10 joules/cm$^2$ ($= 10^5$ joules-cm$^{-3} \times 1$ µm). An even higher energy intensity is easily achieved and melting readily produced, for example, with a stationary, conventional tungsten lamp, emitting light in the wavelength range 0.3 µm to 1.5 µm (with peak power centered about 1.1 µm), at a power intensity of about 60 watts/cm$^2$, and using an exposure time of about 4 seconds (yielding an energy intensity of 240 joules/cm$^2$).

If the non-single crystal material overlying an island 40 and its adjacent seeding area is substantially amorphous (at least fifty percent of the noncrystalline material is amorphous) rather than polycrystalline, then crystallization is readily achieved, with little or no movement of the island, by raising the temperature of the amorphous material above room temperature but below the melting point of the amorphous material. Raising the temperature of any portion of the amorphous material overlying and contacting the seeding area results in the crystallization of this portion, i.e., a crystallization front propagates through the thickness of the portion, starting at the interface between the portion and the underlying substantially single crystal semiconductor material of the seeding area. The propagation speed of this front increases as the temperature of the portion is increased. If the temperature of any portion of the amorphous material overlying and contacting the island 40 is also raised, simultaneously with a contiguous portion of amorphous material overlying and contacting the seeding area, then two effects occur. First, a crystallization front propagates laterally from the contiguous portion of crystallized (formerly amorphous) material overlying and contacting the seeding area into the amorphous material overlying the island. Secondly, a polycrystallization front (a front behind which amorphous material has been converted to polycrystalline material) propagates through the thickness of the portion of amorphous material overlying the island, starting at the amorphous material/island interface. The propagation speed of the polycrystallization front also increases with temperature, but at a different rate from that of the crystallization front. In order to convert the portion of amorphous material overlying and contacting the island into substantially single crystal material, it has been found that the ratio of the propagation speed of the crystallization front laterally traversing the portion to the propagation speed of a polycrystallization front traversing the thickness of the portion should be greater than or equal to the ratio of the (corresponding) lateral dimension of the portion to the smallest thickness (if thickness is nonuniform) of the portion. When the temperature of all of the amorphous material overlying an island and its encircling seeding area is simultaneously raised, then a single crystallization front, initially encircling the island, will propagate (from all directions) through the amorphous material overlying the island, from the periphery of the island toward the center of the island. No portion of this front will traverse more than half the largest lateral extent, e.g. length or width, of the island. Consequentially, crystallization is achieved provided the ratio of propagation speeds is greater than or equal to the ratio of one-half the largest lateral dimension of the island to the smallest thickness of the amorphous material overlying the island.

It has been found that a crystallization front will propagate no more than about 5 µm from the periphery toward the center of the amorphous material overlying an island. Consequently, to crystallize all the amorphous material overlying an island using, for example, a crystallization front or fronts propagating from opposed sides of the island, the largest lateral dimension of an island is preferably less than or equal to about 10 µm.

In general, the temperature profile in the amorphous material overlying an island and its adjacent seeding area, needed to produce the necessary ratio of propagation speeds leading to crystallization, is determined empirically. For example, a given temperature profile is produced in the amorphous material overlying the islands and seeding areas of control samples, and scanning electron micrographs (SEMs) of cross sections of the control samples are made (the crystallization and polycrystallization fronts are readily seen in SEMs) at different instants in time, which permits a measurement of the respective propagation speeds. Once a temperature profile which produces the desired propagation speeds has been found, a knowledge of the propagation speed of the crystallization front, of the dimensions of the island, and of the thickness of the amorphous material, permits a calculation of the minimum time needed to crystallize the amorphous material overlying the island.

Using the above empirical technique, it has been found that one convenient technique for crystallizing amorphous silicon overlying an insulating island and its adjacent seeding area involves uniformly heating (using, for example, any of the energies and energy sources useful for melting) the amorphous silicon overlying both the island and the seeding area to a temperature ranging from about 500 to about 700 degrees C. Temperatures lower than about 500 degrees C are less desirable, although not precluded, because they require undesirably long heating times to achieve crystallization. Temperatures greater than about 700 degrees C are undesirable because they result in an undesirably large amount of amorphous silicon being converted to polycrystalline silicon rather than substantially single crystal silicon.

Amorphous semiconductor material is readily deposited onto the precursor surface 30 (prior to crystallization) using conventional chemical vapor deposition techniques. Alternatively, polycrystalline semiconductor material is deposited onto the surface 30 and converted to amorphous material through impact with ions. The ions, ion dosages and ion energies needed to convert a particular thickness of a particular polycrystalline material to amorphous material are generally determined empirically. One convenient empirical technique is to subject control samples of the thickness of polycrystalline material (to be converted to amorphous material) to various ions, ion dosages and ion energy levels and then make scanning electron micrographs (SEMs) of cross sections of the control samples. The interface between the resulting amorphous material and any residual polycrystalline material is readily seen in such SEMs. Using this technique, it has been found, for example, that a 0.3 µm thick layer of polycrystalline silicon is made amorphous by implanting two sets of $Si^+$ ions into the layer. The energies of the ions associated with one implant should be about 60 keV, while the energies of the ions associated with the other implant should be about 160 keV. The corresponding dosage level for each implant should be about $2 \times 10^{15}$ $cm^{-2}$.

The crystallization of the layer 45 results in the formation of substantially single crystal semiconductor material 220 covering each island 40, which is now further processed with the IC mask set (which includes the device mask) to complete the fabrication of the SOI IC. That is, the device mask (of the IC mask set) is used to form a FD 230, i.e., a layer of electrically insulating material 230 (see FIGS. 8 and 11), which is external to, and encircles, a device region (a region which is to contain one or more devices) in the substantially single crystal semiconductor material 220 covering each island 40. If, for example, the non-SORT process is used to form the FD 230, and if the crystallized layer 220 is of Si, then this layer is oxidized partially through its thickness, and the oxide covering the device regions is selectively (using the device mask) lithographically removed (see FIGS. 17 and 8). Alternatively, if the SORT process is used to form the FD 230, then (as shown in FIGS. 9-11), for example, successive layers 190 and 200 of $SiO_2$ and $Si_3N_4$ are formed on the layer 220, the $SiO_2$ and $Si_3N_4$ are patterned (using the device mask) to expose the crystallized layer 220 external to the device regions, and the exposed regions of the layer 220 are oxidized to form the FD. After the formation of the FD, the remaining masks of the IC mask set are used to form an IC component in the substantially single crystal material 220 overlying each island 40.

Example

The following shows that the described method for fabricating SOI devices avoids the displacement problem exhibited by the conventional lateral seeding process.

A p-type, 7.62 cm (3-inch) diameter silicon wafer, having an upper major surface with a (100) orientation, was heated in an oven at 1000 degrees C for 40 minutes to form a layer of $SiO_2$ on the wafer's surface. The thickness of the $SiO_2$ layer was measured with an ellipsometer and found to be about 50 nm. Conventional low pressure chemical vapor deposition (LPCVD) techniques were then used to deposit a layer of $Si_3N_4$ onto the oxidized, upper major surface of the wafer. The thickness of the $Si_3N_4$ was also measured with an ellipsometer and found to be about 125 nm. Then, a 1 µm-thick layer of HPR-204 positive photoresist (the photoresist was purchased from the Hunt Chemical Corporation of Garden City, Long Island) was spin-deposited onto the $Si_3N_4$.

The photoresist was exposed to light having a wavelength of about 400 nm through a mask to define a periodic array of rectangles in the photoresist. Each rectangle of the array was 6 μm in width and 16 μm in length. The center-to-center spacing between the rectangles in a first direction was about 20 μm, while the center-to-center spacing in a second direction, transverse to the first, was about 28 μm. The resist was developed with LSI developer (for the HPR-204 photoresist), also sold by Hunt Chemical Corporation, for 2 minutes, to produce a corresponding array of rectangular apertures in the resist. The pattern in the resist was then transferred into the $Si_3N_4$ and $SiO_2$ layers by plasma etching these layers, through the patterned resist, in an atmosphere of $CHF_3$. The resist was removed with a solvent which includes $H_2SO_4$ and $H_2O_2$.

The wafer was then oxidized in a wet ambient (using the patterned layer of $Si_3N_4$ as an oxidation mask), with conventional techniques, at a temperature of 1000 degrees C for about 5 hours, to produce a periodic array of rectangular oxide islands on the surface of the wafer. The thickness of these oxide islands was measured with an ellipsometer and found to be about 1 μm. About half the thickness of the oxide islands extended above the original surface of the wafer.

In order to achieve a substantially planar wafer surface, the oxide islands were etched back using a 3-step process. During the first step, the oxide islands were etched with buffered HF to reduce the thickness of the islands by about 200 nm, and during the second step, the patterned $Si_3N_4$ layer was etched away with hot phosphoric acid. During the third step, the oxide islands were again etched with buffered HF to further reduce the thickness of the islands by about 200 nm. The patterned $SiO_2$ layer (originally lying beneath the $Si_3N_4$) was also etched away during the third step.

A 400 nm-thick layer of polysilicon was deposited onto the wafer by conventional LPCVD techniques, and annealed in an $N_2$ atmosphere, at 1100 degrees C, for 30 minutes. A portion of the deposited polysilicon was then crystallized by shining a stationary argon laser (stationary relative to the wafer surface), emitting light at a wavelength of about 488 nanometers, at a power of about 10 watts, onto the polysilicon. The laser, which produced a spot size of about 60 μm, was operated for about 0.5 seconds. The energy density within the laser spot was sufficient to melt the polysilicon impinged by the spot.

The wafer was etched for about 5 seconds with an etchant which includes 75 grams of $CrO_3$ dissolved in a solution which includes 1 liter of $H_2O$ and 2 liters of HF. This etchant preferentially etches grain boundaries, thus making grain boundaries visible under an optical microscope.

The etched wafer was observed, and photographed, under an optical microscope at a magnification of about 847. The photograph revealed almost a complete absence of grain boundaries within the polysilicon impinged by the laser spot, but did reveal a large number of grain boundaries within the polysilicon outside the laser spot. Thus, the polysilicon impinged by the laser light had been crystallized.

The center-to-center spacing between adjacent oxide islands in the photograph was measured with a ruler [the scale was 2.54 cm (1 inch) = 30 μm]. In particular, the spacing between two adjacent islands outside the laser spot, between two adjacent islands within the laser spot, and between an island within the laser spot and an adjacent island outside the laser spot was measured. In all cases, the spacing in the first direction was about 20 μm, while the spacing in the second direction was about 28 μm. Thus, there was essentially no movement of any of the islands.

## Claims

1. A semiconductor device fabrication method comprising :
   forming an island (40) of electrically insulating material on a surface of a substrate (20), the boundaries of the island being lithographically defined by a pattern delineating device, the island being substantially encircled by an exposed seeding area (170) of substantially single-crystal semiconductor material ;
   forming a layer of non-single-crystal semiconductor material (45) on the island (40) an the seeding area (170) ;
   raising the temperature of the non-single-crystal semiconductor material to produce a region of single-crystal semiconductor material (220) overlying the island and the adjacent, encircling seeding area ; and
   fabricating a device in the said region ; CHARACTERISED IN THAT
   in the temperature raising step, the non-single-crystal semiconductor material overlying the island and the seeding area is all raised in temperature substantially simultaneously ; and
   a field dielectric (230) is formed to encircle the boundaries of the said region, the said boundaries of the region being defined by a pattern delineating device which produces a pattern substantially identical to that used to define the boundaries of the island.

2. A method as claimed in claim 1 wherein said temperature raising step includes the step of substantially melting the non-single crystal semiconductor material both on the island and on the seeding area.

3. A method as claimed in claim 2 wherein the largest lateral extent of the island is less than about 100 μm.

4. A method as claimed in claim 1 wherein said non-single crystal semiconductor material is amorphous semiconductor material and in said temperature raising step the temperature of said non-single crystal semiconductor material is raised to a point below the melting temperature of said amorphous material.

5. A method as claimed in claim 4 wherein the largest lateral extent of said island is less than about 10 μm.

6. A method as claimed in any of the preceding claims wherein the thickness of said substantially single crystal semiconductor material overlying said island is in the range 20 nm to 1 μm.


## Ansprüche

1. Verfahren zur Herstellung von Halbleiterbauelementen mit den Schritten :

Bilden einer Insel (40) aus elektrisch isolierendem Material auf einer Oberfläche eines Substrats (20), wobei die Grenzen der Insel lithographisch durch ein musterabgrenzendes Bauteil definiert sind und die Insel im wesentlichen durch einen freigelegten Keimbereich (170) aus im wesentlichen einkristallinem Halbleitermaterial umgeben ist,

Bilden einer Schicht aus nicht einkristallinem Halbleitermaterial (45) auf der Insel (40) und dem Keimbereich (170),

Erhöhen der Temperatur des nicht einkristallinen Halbleitermaterials zur Erzeugung einer Zone aus einkristallinem Halbleitermaterial (220), die die Insel und den benachbarten, umgebenden Keimbereich überdeckt, und Herstellen eines Bauteils in der Zone, dadurch gekennzeichnet, daß bei dem Temperaturerhöhungsschritt das nicht einkristalline Halbleitermaterial über der Insel und dem Keimbereich im wesentlichen gleichzeitig in seiner Temperatur erhöht wird und daß ein Felddielektrikum (230) so gebildet wird, daß es die Grenzen der Zone umgibt, wobei die Grenzen der Zone durch ein musterabgrenzendes Bauteil definiert werden, welches ein Muster erzeugt, das im wesentlichen identisch mit dem ist, das zur Definition der Grenzen der Insel benutzt worden ist.

2. Verfahren nach Anspruch 1, bei dem der Temperaturerhöhungsschritt den Schritt enthält, das nicht einkristalline Halbleitermaterial auf der Insel und auf dem Keimbereich im wesentlichen zu schmelzen.

3. Verfahren nach Anspruch 2, bei dem die größte seitliche Ausdehnung der Insel kleiner als etwa 100 μm ist.

4. Verfahren nach Anspruch 1, bei dem das nicht einkristalline Halbleitermaterial amorphes Halbleitermaterial ist und bei dem Temperaturerhöhungsschritt die Temperatur des nicht einkristallinen Halbleitermaterials auf einen Punkt unterhalb der Schmelztemperatur des amorphen Materials erhöht wird.

5. Verfahren nach Anspruch 4, bei dem die größte seitliche Ausdehnung der Insel kleiner als etwa 10 μm ist.

6. Verfahren nach einem der vorhergehenden Ansprüche, bei dem die Dicke des im wesentlichen einkristallinen Halbleitermaterials über der Insel im Bereich von 20 nm bis 1 μm beträgt.


## Revendications

1. Un procédé de fabrication de dispositifs à semiconducteurs comprenant les étapes suivantes :

on forme un îlot (40) de matière électriquement isolante sur une surface d'un substrat (20), les frontières de l'îlot étant définies par lithographie au moyen d'un dispositif de dessin de motif, et l'îlot étant pratiquement encerclé par une zone d'ensemencement à nu (170) en une matière semiconductrice pratiquement monocristalline ;

on forme une couche de matière semiconductrice non monocristalline (45) sur l'îlot (40) et la zone d'ensemencement (170) ;

on élève la température de la matière semiconductrice non monocristalline pour produire une région de matière semiconductrice monocristalline (220), recouvrant l'îlot et la zone d'ensemencement adjacente qui encercle l'îlot, et

on fabrique un dispositif dans la région précitée ; CARACTERISE EN CE QUE

dans l'étape d'élévation de température, on élève de façon pratiquement simultanée la température de toute la matière semiconductrice non monocristalline qui recouvre l'îlot et la zone d'ensemencement ; et

on forme un diélectrique de champ (230) de façon à encercler les frontières de la région précitée, ces frontières de la région étant définies par un dispositif de dessin de motif qui produit un motif pratiquement identique à celui qui est utilisé pour définir les frontières de l'îlot.

2. Un procédé selon la revendication 1, dans lequel l'étape d'élévation de température comprend l'étape qui consiste à faire fondre pratiquement la matière semiconductrice non monocristalline à la fois sur l'îlot et sur la zone d'ensemencement.

3. Un procédé selon la revendication 2, dans lequel la plus grande étendue latérale de l'îlot est inférieure à environ 100 μm,

4. Un procédé selon la revendication 1, dans lequel la matière semiconductrice non monocristalline est une matière semiconductrice amorphe, et dans l'étape d'élévation de température, la température de la matière semiconductrice non monocristalline est élevée jusqu'à un point inférieur à la température de fusion de la matière amorphe.

5. Un procédé selon la revendication 4, dans lequel la plus grande étendue latérale de l'îlot est inférieure à environ 10 μm.

6. Un procédé selon l'une quelconque des revendications précédentes, dans lequel l'épaisseur de la matière semiconductrice pratiquement monocristalline qui recouvre l'îlot est dans la plage de 20 nm à 1 μm.

FIG. 1

FIG. 2

FIG. 3

FIG. 4

FIG. 5

FIG. 6

160

40

45

30

20

170

170

FIG. 9

40

200

190

220

20

FIG. 7

40

230

220

20

FIG. 10

200

190

230

230

220

20

40

FIG. 8

230

220

40

230

20

FIG. 11

230

220

40

230

20